# EUROPEAN PATENT APPLICATION

(11) **EP 4 729 789 A1**
(43) Date of publication of application: **22.04.2026**
(21) Application number: 25209184.8
(22) Date of filing: 16.10.2025
(51) Int. Cl.: F04D 29/58, F04D 25/08, F04D 19/00, F04D 25/06, F04D 29/54

(54) **HEAT REJECTION FAN COOLING**

(30) Priority: 16.10.2024 US 202463708037 P; 14.10.2025 US 202519357792
(71) Applicant: Vertiv Corporation, Westerville, OH 43082 (US)
(72) Inventor: COLE, Andrew Nathan, 43082 Westerville (US); BUSCH, Gregory Thomas, 43082 Westerville (US)
(74) Representative: Ambroz, Simon

(57) **Abstract**

A heat rejection fan assembly may include a set of fan blades. The heat rejection fan assembly may include a fan motor coupled to the set of fan blades via a motor shaft and configured to cause the set of fan blades to: cause a first air volume to move through a heat exchanger; and move the first air volume through a shroud opening. The heat rejection fan assembly may include a fan motor cooling sub-system configured to cool the fan motor.

## Description

### CROSS-REFERENCE TO RELATED APPLICATIONS

The present application claims the benefit under 35 U.S.C § 119(e) to U.S. Provisional Application No. 63/708,037, filed October 16, 2024.

### TECHNICAL FIELD

The present disclosure relates to cooling systems, and more particularly to cooling fans for industrial cooling systems.

### BACKGROUND

Industrial cooling systems, such as cooling systems for data centers, often utilize large outdoor heat rejection units, such as that include a coil, that circulates refrigerant, and a fan that forces ambient air against the coil, causing the transfer of heat from the coil to the air, which is pushed away from the heat rejection unit by the fan. While data centers are typically designed with cooling systems that can manage the heat that the data centers are predicted to generate, increases in ambient air temperatures (via local or global warming) and/or increases in server-generated heat, such as increased loads due to artificial intelligence (AI)-based processing, can cause air temperatures within the condenser (e.g., rejection air) to rise above normal levels. The increased air temperature can reduce the life expectancy of components of the heat rejection unit, such as a fan motor. One option to resolve this problem is to replace the original condenser with one of increased capacity. However, replacement condensers are expensive and may not be able to fit within the footprint of the original heat rejection unit.

Therefore, there is a need for a cooling system and method that cures one or more shortfalls of the existing approaches.

### SUMMARY

Accordingly, the present disclosure is directed toward a heat rejection fan assembly, a system, and a method for cooling a heat rejection fan assembly within a cooling system.

In some examples, the techniques described herein relate to a heat rejection fan assembly including: a set of fan blades: a fan motor coupled to the set of fan blades via a motor shaft and configured to cause the set of fan blades to: cause a first air volume to move through a heat exchanger; and move the first air volume through a shroud opening; and a fan motor cooling sub-system configured to cool the fan motor.

In some examples, the techniques described herein relate to a heat rejection unit including: a shroud including a shroud opening; a heat rejection coil disposed within the shroud; and a heat rejection fan assembly, the heat rejection fan assembly including: a set of fan blades: a fan motor coupled to the set of fan blades via a motor shaft and configured to cause the set of fan blades to: cause a first air volume to move through a heat exchanger; and move the first air volume through a shroud opening; and a fan motor cooling sub-system configured to cool the fan motor.

In some examples, the techniques described herein relate to a fan motor cooling sub-system for a heat rejection fan assembly configured to cause a first air volume to move through a heat exchanger including: a coolant entry duct including: a second air volume outlet disposed near a fan motor; and a second air volume inlet disposed at a second air volume, wherein the second air volume moves from the second air volume inlet to the second air volume outlet and cools the fan motor.

In some examples, the techniques described herein relate to a method for controlling an operational temperature of a fan motor within a cooling system including: receiving a temperature measurement from a sensor within the cooling system; determining if the temperature measurement is above a threshold value; and if the temperature measurement is above the threshold value, activating a coolant pump.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims.
FIG. 1A illustrates a perspective view of a cooling system, in accordance with one or more examples of the disclosure.
FIG. 1B illustrates a cross-sectional view of a simplified schematic of the cooling system, in accordance with one or more examples of the disclosure.
FIG. 2A illustrates a cross-sectional view of the heat rejection fan assembly within the cooling system, in accordance with one or more examples of the disclosure.
FIG. 2B illustrates a cross-sectional view of the heat rejection fan assembly within the cooling system, in accordance with one or more examples of the disclosure.
FIG. 2C illustrates a cross-sectional view of the heat rejection fan assembly within the cooling system, in accordance with one or more examples of the disclosure.
FIG. 2D illustrates a cross-sectional view of the heat rejection fan assembly within the cooling system, in accordance with one or more examples of the disclosure.
FIG. 2E illustrates a cross-sectional view of the heat rejection fan assembly within the cooling system, in accordance with one or more examples of the disclosure.
FIG. 3A illustrates a simplified cross-sectional view of a cooling system that includes a coolant entry duct, in accordance with one or more examples of the disclosure.
FIG. 3B illustrates a front view of a set of fan blades for the heat rejection fan assembly, in accordance with one or more examples of the disclosure.
FIG. 4 illustrates a block diagram depicting the cooling system, in accordance with one or more examples of the disclosure.
FIG. 5 illustrates a process flow diagram depicting a method for controlling an operational temperature of a fan motor within a cooling system, in accordance with one or more examples of the disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein, a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein, any reference to "one example" or "examples" means that a particular element, feature, structure, or characteristic described in connection with the example is included in at least one example disclosed herein. The appearances of the phrase "in examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Reference will now be made in detail to the subject matter disclosed, which is illustrated in the accompanying drawings.

Disclosed are fan motor cooling sub-systems and methods for using the fan motor cooling sub-systems. The fan motor cooling sub-systems may be incorporated within a fan, such as a fan in a heat rejection fan assembly. The fan motor cooling sub-system may also be incorporated within a cooling system, such as a heat rejection unit. The fan motor cooling sub-system may include components that separate rejection air (e.g., a first air volume) that has been warmed from exposure to heat exchangers from "fresh" air (e.g., a second air volume) that has not been exposed to heat exchangers. For example, the second air volume may include air that has not moved through a heat exchanger. The fan motor cooling sub-system may also include active cooling componentry, such as a circulating coolant, to cool down the fan motor.

Examples of the present disclosure are particularly advantageous, as the fan motor cooling sub-systems cool down the fan motor, reducing motor temperature and improving motor life expectancy. The examples may also be implemented without requiring a change in fan size or output. The fan motor cooling sub-systems are novel as they provide a separate cooling air flow to the fan's motor instead of relying on the main air flow, as current cooling systems use the main flow to cool the fan motor.

As used herein, the term "heat rejection unit" refers to any type of device, system, or system component that removes heat from a refrigerant, fluid, or space, and transfers the heat to the surrounding environment (e.g., air or water). For example, a heat rejection unit may include, but not be limited to, an air-cooled condenser, a water-cooled condenser, a cooling tower, a dry cooler, and an evaporative condenser. For instance, while examples herein may illustrate a heat rejection fan assembly within an air-cooled condenser with cooling coils, the heat rejection fan assembly may be integrated into any type of heat rejection unit as stated above.

The heat rejection units may further include one or more heat exchangers. Heat exchangers may include, but not be limited to, finned-tube coil heat exchangers, platetype condenser heat exchangers, shell and tube heat exchangers, and plate heat exchangers (e.g., brazed plate heat exchangers). For example, while examples herein may illustrate a heat exchanger as a set of cooling coils for an air-cooled condenser, the heat exchanger may include any type of cooling technology.

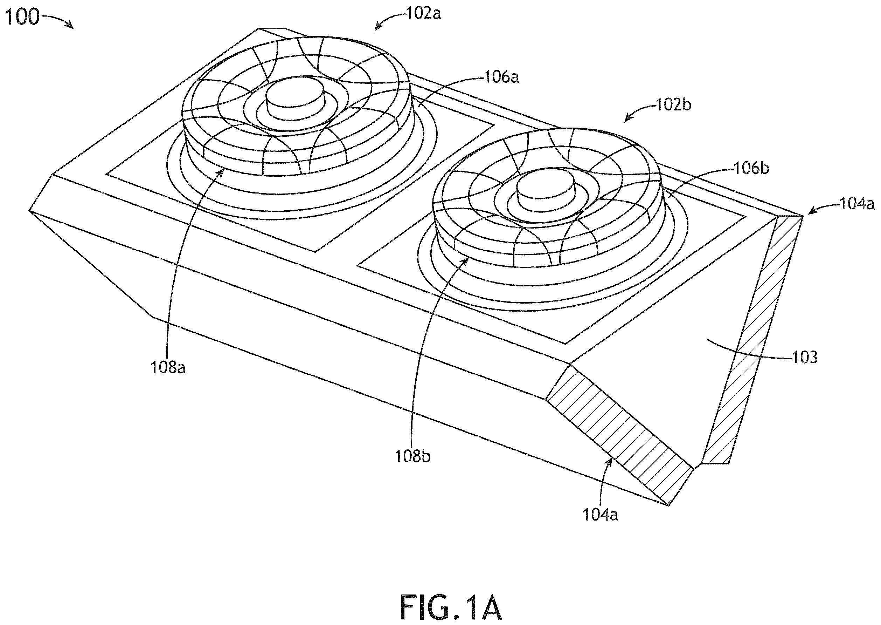

FIG. 1A illustrates a perspective view of a cooling system 100, in accordance with one or more examples of the disclosure. The cooling system 100 may be used for any purpose including, but not limited to, the cooling of data centers or telecommunication centers. The cooling system 100 may include a heat rejection unit.

In examples, the cooling system 100 includes one or more heat rejection fan assemblies 102a, 102b and one or more heat exchangers incorporated into a housing 103. For example, one or more heat exchangers 104a, 104b (e.g., coils) may be incorporated into one or more sides of the housing 103. In another example, the one or more heat rejection fan assemblies 102a, 102b may be incorporated into one or more shrouds 106a, 106b of the housing. For instance, the one or more heat rejection fan assemblies 102a, 102b may be incorporated or disposed into one or more shroud openings 108a, 108b within the one or more shrouds 106a, 106b.

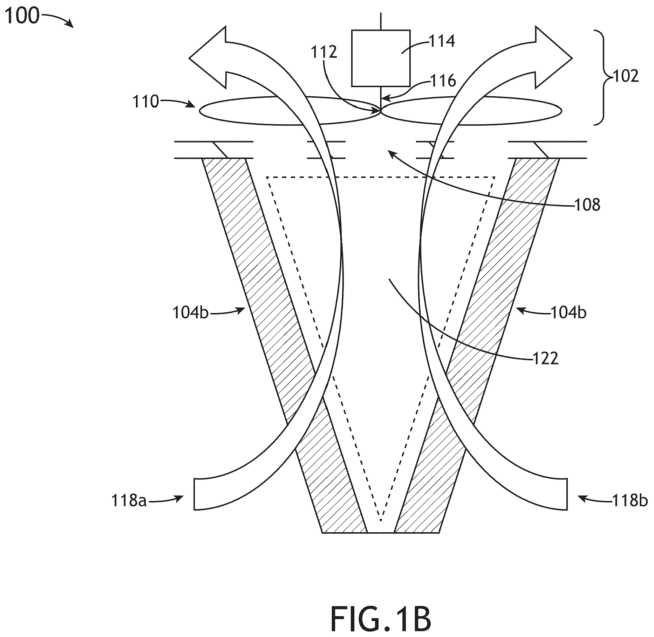

FIG. 1B illustrates a side view of a simplified schematic of the cooling system 100, in accordance with one or more examples of the disclosure. In examples, a heat rejection fan assembly 102 includes a set of one or more fan blades 110 connected to each other at a hub 112. The heat rejection fan assembly 102 further includes a fan motor 114 coupled to the hub 112 (e.g., via a motor shaft 116). When the set of fan blades 110 rotates, air, such as fresh air and/or ambient air, is drawn through the heat exchangers 104a, 104b (e.g., as shown by air currents 118a, 118b) and out through a shroud opening 108. Heat from the heat exchangers 104a, 104b is transferred to the air as the air travels through the heat exchangers 104a, 104b, resulting in the production of rejection air, with air having flowed through the heat exchangers referred to as a first air volume 122 (e.g., as indicated by the dotted triangle). The fan motor 114 may include any type of electrical motor including, but not limited to, an electronically commutated (EC) electric motor and a National Electric Manufacturers Association (NEMA)-standardized electric motor.

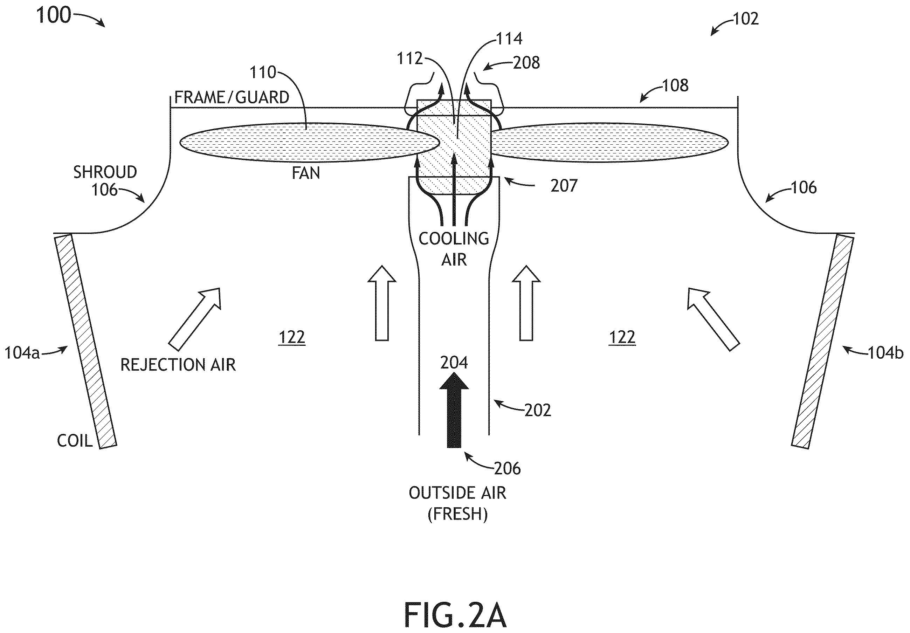

FIG. 2A illustrates a cross-sectional view of the heat rejection fan assembly 102 within the cooling system 100, in accordance with one or more examples of the disclosure. In examples, the heat rejection fan assembly 102 includes a fan motor cooling sub-system configured to cool the fan motor 114. For example, the fan motor cooling sub-system may include a coolant entry duct 202 fluidly couplable to the fan motor 114 and configured to selectively cause, or force, a second air volume 204 (e.g., fresh air, ambient air, or nonrejection air) flowing through an opening in the cooling system 100, such as an opening in the housing 103, to contact the fan motor 114, where the second air volume 204 cools the fan motor 114 directly or by minimizing the amount of hot air impinging on the motor. The second air volume 204 may be at least partially biased or moved due to the reduced air pressure produced on the opposite side of the fan blades 110 when the heat rejection fan assembly 102 is in use. The coolant entry duct 202 may also include a second air volume inlet 206 (e.g., opposite a second air volume outlet 207) that draws fresh air (e.g., the second air volume 204) into the housing 103 or heat rejection space of the cooling system 100 while preventing the first air volume 122 from mixing with the second air volume 204. The second air volume 204 is cooler than the first air volume 122, and therefore provides more efficient cooling of the fan motor 114 than the first air volume 122. The fan motor cooling sub-system may further include a coolant exit duct 208 configured to direct the second air volume 204 away from the fan motor 114. The ducts 202, 208 may also provide an insulating boundary layer between the first air volume 122 and the second air volume 204. The coolant entry duct 202 and the coolant exit duct 208 may be attached directly to the fan motor 114 or may be positioned adjacent to the fan motor 114 (e.g., i.e. one or more duct frame elements).

Because the diameter of the coolant entry duct 202 is relatively narrow as compared to the volume of the heat rejection unit chamber, the coolant entry duct 202 only slightly reduces the flow of the first air volume 122 through the heat rejection fan assembly 102. For example, the coolant entry duct 202 may reduce the flow of the first air volume by less than 2% as compared to a cooling system that does not include the coolant entry duct 202.

The coolant entry duct 202 and/or the coolant exit duct 208 provide an easy-to-implement solution to the fan motor heat problem, as the ducts 202, 208 provide a second air volume 204 that is 10°F to 20°F cooler than the first air volume 122. This air stream will cool the fan motor 114 and insulate the fan motor 114 from the higher temperatures of the first air volume 122. The pressure drop created at the underside of the fan blades 110 draws air through the ducts 202, 208. The second air volume 204 at the center of the heat rejection fan assembly 102 is less turbulent and may create a boundary layer, further improving motor fan cooling. The ducts 202, 208 may be added onto existing heat rejection fan assemblies 102, such as heat rejection fan assemblies 102 operating within their maximum allowable temperature range, to reduce motor temperature and improve life expectancy.

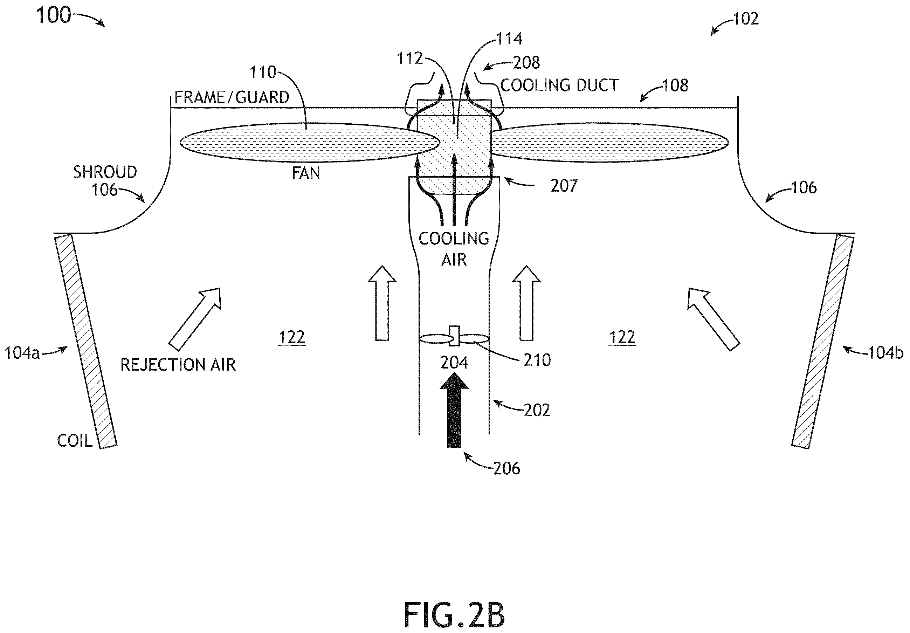

FIG. 2B illustrates a cross-sectional side view of the heat rejection fan assembly 102 within the cooling system 100, in accordance with one or more examples of the disclosure. In examples, the fan motor cooling sub-system includes one or more cooling duct fans 210, or other cooling device, disposed within the coolant entry duct 202 and/or coolant exit duct 208. The one or more cooling duct fans 210 biases, forces, or otherwise moves the second air volume 204 through the coolant entry duct 202 and/or coolant exit duct 208. A portion of the second air volume 204 may then contact the fan motor 114. The cooling duct fan 210 may include any type of air-moving device and/or heat exchanger with external cooling media and be disposed within the ducts 202, 208 or at the entrance and/or exits of the ducts 202, 208. Other cooling devices that may be included within the fan motor cooling sub-system may include a heat exchanger that utilizes a cooling fluid and/or a fan operationally coupled to a heat exchanger.

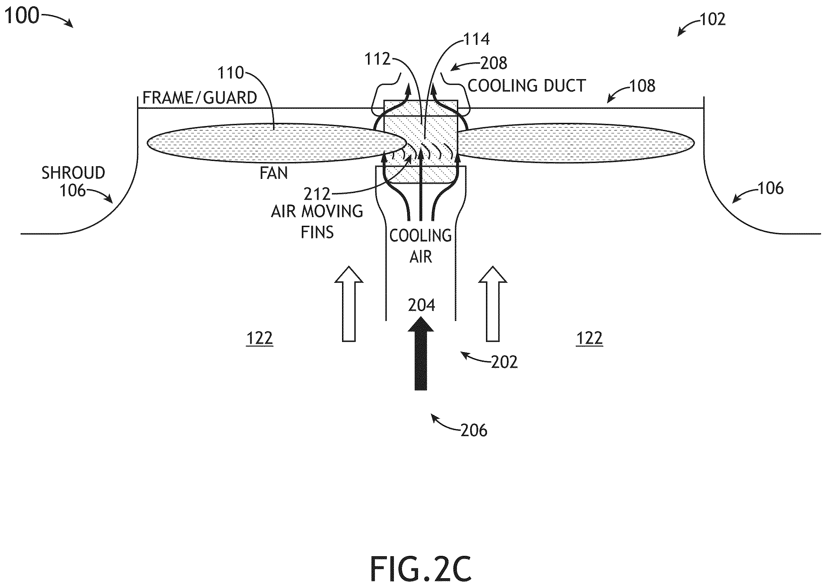

FIG. 2C illustrates a cross-sectional side view of the heat rejection fan assembly 102 within the cooling system 100, in accordance with one or more examples of the disclosure. In examples, the fan motor cooling sub-system includes a set of air-moving fins 212 (e.g., a set of cooling fins) configured to direct the second air volume 204 through a shroud opening 108. The set of air-moving fins 212 may be configured as static fins or moving fins. For example, the set of air-moving fins 212 may be incorporated into the hub 112 or fairing of the heat rejection fan assembly 102. Therefore, when the hub 112 rotates, the set of air-moving fins 212 also rotates, causing the second air volume 204 to flow through the shroud opening 108. In another example, a surface of the fan motor 114 may include a set of air-moving fins 212 that direct the cooler second air volume 204 on a path along the fan motor 114, increasing the efficiency by which the second air volume 204 can cool the fan motor 114. In some examples, both the hub 112 and the fan motor 114 include respective moving and static sets of air-moving fins 212.

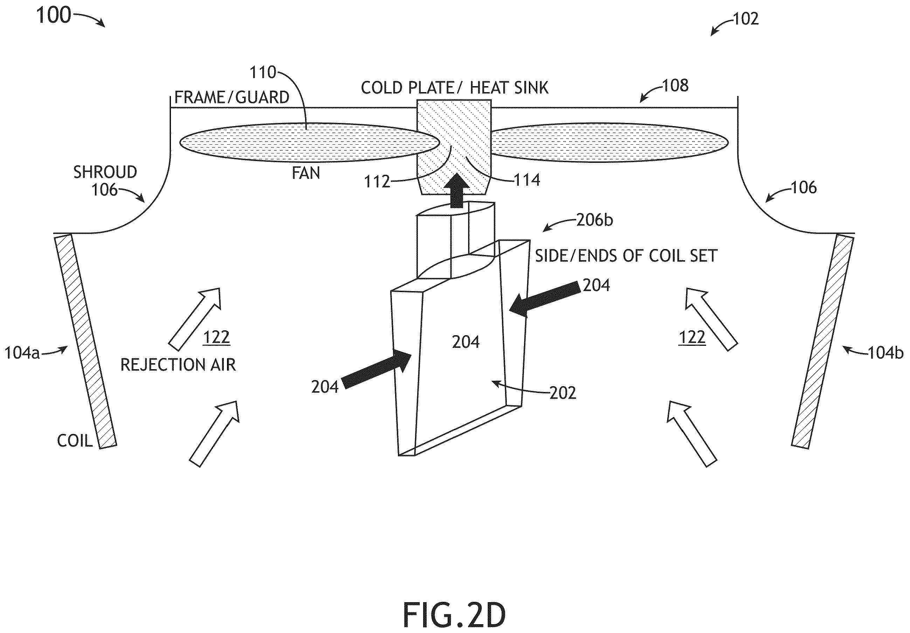

FIG. 2D illustrates a cross-sectional view of the heat rejection fan assembly 102 within the cooling system 100, in accordance with one or more examples of the disclosure. In examples, the coolant entry duct 202 includes one or more second air volume inlets 206a, 206b that face away from the heat exchangers 104a, 104b. For example, and as shown in FIG. 2D, the coolant entry duct 202 may include one or more second air volume inlets 206a, 206b positioned so that the second air volume 204 is received from the sides of the cooling system 100, where heat exchangers104a, 104b are not positioned. The second air volume 204 may originate from outside the cooling system 100, wherein the second air volume 204 enters as fresh air through an opening in the housing 103 or other opening within the cooling system 100 which then passes through the coolant entry duct. In an alternative example, the second air volume 204 originates as a portion of the first air volume 122 that has a lower temperature than other portions of the first air volume 122. For example, it may be determined that a portion of the first air volume 122, such as portions of the first air volume 122 distal to the heat exchangers 104a, 104b, may have temperatures cooler than portions of the first air volume 122 that are adjacent to the heat exchangers 104. These cooler portions of the first air volume 122 may be then moved into the coolant entry duct 202 (e.g., designated as a second air volume 204), cooling the fan motor 114. In examples, the second air volume inlets 206a, 206b are positioned orthogonal to the rotor shaft 116, as well as facing away from the heat exchangers 104a, 104b.

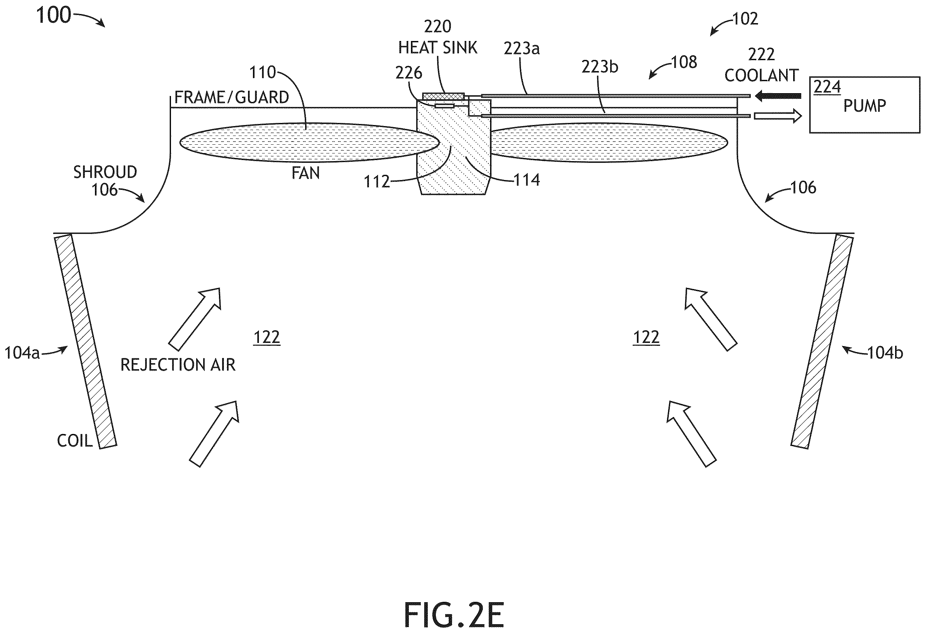

FIG. 2E illustrates a cross-sectional view of the heat rejection fan assembly 102 within the cooling system 100, in accordance with one or more examples of the disclosure. In examples, the fan motor cooling sub-system includes a heat sink 220 or cold plate thermally coupled to the fan motor 114, which is cooled by circulating coolant 222. For example, the fan motor cooling sub-system may include coolant 222 that is circulated through coolant lines 223a, 223b via a pump 224 (e.g., the coolant lines 223a, 200b may be thermally coupled to the heat sink 220). In this manner, heat from the fan motor 114 is absorbed by the heat sink 220, which is displaced by the circulating coolant 222. The fan motor cooling sub-system may also use, or include, the pump 224, a chiller, a refrigeration sub-system, or other devices to reduce the temperature of the coolant 222. The circulating coolant 222 may include any type of liquid or vapor including, but not limited to, water. For example, the coolant 222 may include any compatible refrigerant. Because of the cooling provided by the coolant 222, the cooling system 100 may not be required to move a second air volume 204 (e.g., the cooling system 100 may be configured to move only the first air volume 122). The fan motor cooling sub-system may include one or more sensors 226 configured to measure a temperature of the heat sink 220 and/or other components of the cooling system 100.

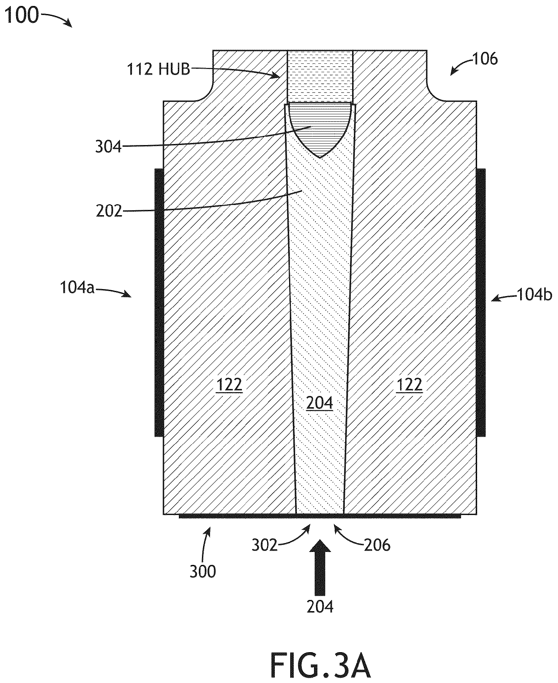

FIG. 3A illustrates a simplified cross-sectional view of a cooling system 100 that includes a coolant entry duct 202, in accordance with one or more examples of the disclosure. Also illustrated is an end surface 300 of the cooling system 100 that includes an end opening 302 coupled to the second air volume inlet 206 which allows fresh air (e.g., second air volume 204) to flow into the coolant entry duct 202 to cool the fan motor 114 (hidden from view by fairing 304). The end opening 302 and/or second air volume inlet 206 may have a diameter within a range of one cm to 30 cm or within a range of three cm to ten cm. For instance, the end opening 302 and/or second air volume inlet 206 may have a diameter of approximately 7.6 cm (3 inches). In another instance, the end opening 302 and/or second air volume inlet 206 may have a diameter greater than 30 cm. The fairing 304 may include a cone shape, shroud shape, or other shape that prevents the second air volume 204 from abruptly contacting the fan motor 114 and/or disrupting flow of the second air volume 204.

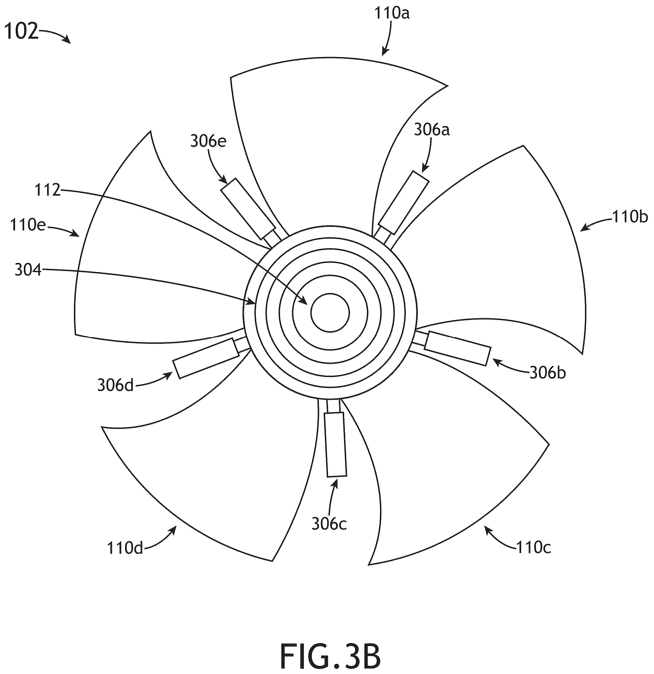

FIG. 3B illustrates a front view of a set of fan blades 110a-e for the heat rejection fan assembly 102, in accordance with one or more examples of the disclosure. In examples, the heat rejection fan assembly 102 includes one or more mini blades 306a, 306b coupled to the hub 112 and/or fairing 304. The one or more mini blades 306 are configured to generate airflow to the core volume of the cooling system 100 (e.g., an area occupied by the second air volume 204).

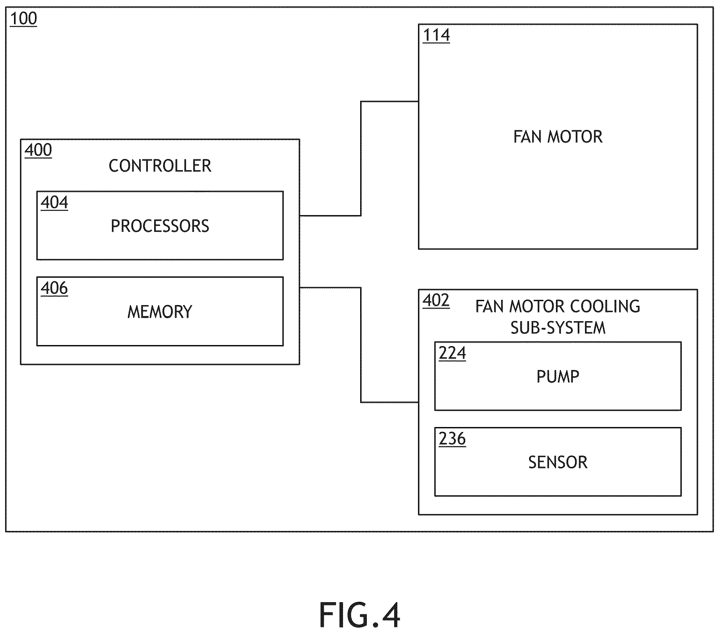

FIG. 4 illustrates a block diagram depicting the cooling system 100, in accordance with one or more examples of the disclosure. In examples, the cooling system includes one or more controllers 400 communicatively coupled to the fan motor 114 and a fan motor cooling sub-system 402, such as the fan motor cooling sub-system 402 of FIG. 2E. For example, the fan motor cooling sub-system 402 may include one or more pumps 224 and/or one or more chillers. The one or more controllers 400 are configured to provide and/or control functionality of the fan motor 114 and/or fan motor cooling sub-system 402. The one or more controllers 400 include one or more processors 404 configured to execute program instructions maintained on a memory 406.

It should be understood that the cooling system 100 may not include a controller 400. For example, the fan motor 114 may be controlled by a switch. Therefore, the above description should not be interpreted as a limitation on the examples of the present disclosure but merely as an illustration.

It should be understood that any of the fan motor cooling subsystems 402 described herein may include one or more components of the other fan motor cooling subsystems 402 as described herein. For example, a fan motor cooling system may include both a cooling entry duct 202 and coolant lines 223a, 223b for circulating a coolant 222. Therefore, the above description should not be interpreted as a limitation on the examples of the present disclosure but merely as an illustration.

The one or more processors 404 of the controllers 400 may include any processor or processing element known in the art. For the purposes of the present disclosure, the term "processor" or "processing element" may be broadly defined to encompass any device having one or more processing or logic elements (e.g., one or more microprocessor devices, one or more application-specific integrated circuit (ASIC) devices, one or more field programmable gate arrays (FPGAs), or one or more digital signal processors (DSPs)). In this sense, the one or more processors 404 may include any device configured to execute algorithms and/or instructions (e.g., program instructions stored in memory 406). In some examples, the one or more processors 404 may be embodied as a desktop computer, mainframe computer system, workstation, image computer, parallel processor, networked computer, or any other computer system configured to execute program instructions. Further, the steps described throughout the present disclosure may be carried out by a single controller or, alternatively, multiple controllers. Additionally, the controllers 400 may include one or more controllers housed in a common housing or within multiple housings.

The memory 406 may include any storage medium known in the art suitable for storing program instructions executable by the associated one or more processors 404. For example, the memory 406 may include a non-transitory memory medium. By way of another example, the memory 406 may include, but is not limited to, a read-only memory (ROM), a random-access memory (RAM), a magnetic or optical memory device (e.g., disk), a magnetic tape, a solid-state drive and the like. It is further noted that the memory 406 may be housed in a common controller housing with the one or more processors 404. In some examples, the memory 406 may be located remotely with respect to the physical location of the one or more processors 404 and the controllers 400. For instance, the one or more processors 404 of the controllers 400 may access a remote memory (e.g., server), accessible through a network (e.g., internet or intranet).

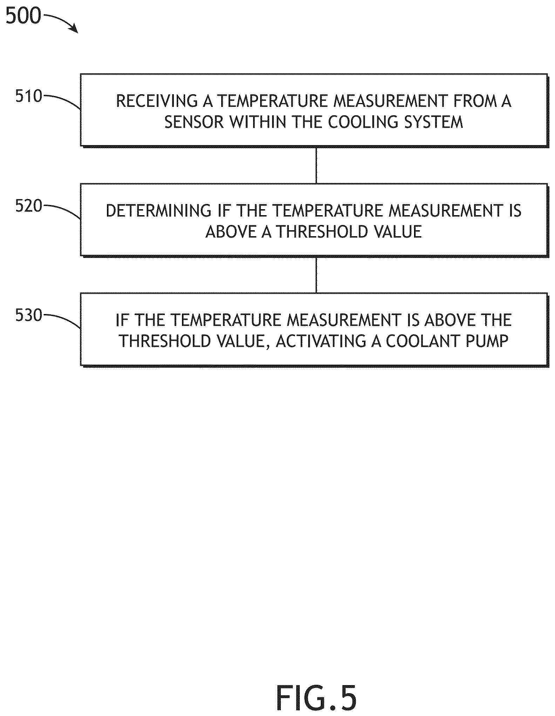

FIG. 5 illustrates a process flow diagram depicting a method 500 for controlling an operational temperature of a fan motor 114 within a cooling system 100, in accordance with one or more examples of the disclosure. For example, the method 500 may be used by the cooling system 100 to prevent the fan motor 114 from overheating. The method 500 may be utilized for cooling systems 100 that include controllable fan motor cooling sub-systems 402, such as the fan motor cooling sub-system 402 depicted in FIG. 2E.

In examples, the method 500 includes step 510 of receiving a temperature measurement from a sensor within the cooling system 100. For example, the controller 400 may receive from the sensor 236 on or near the heat sink 220 a temperature measurement indicating an operating temperature of the cooling system 100 and/or fan motor 114.

In examples, the method 500 includes step 520 of determining if the temperature measurement is above a threshold value. For example, the controller may include in memory 406 a threshold value or operational value for the fan motor 11 and compare that value to the temperature measurement.

In examples, the method 500 includes step 530 of, if the temperature measurement is above the threshold value, activating a coolant pump 224. For example, if the one or more processors 404 determines that the measured temperature is higher than the threshold temperature, the one or more processors 404 may cause the pump 224 to activate, causing coolant 222 to circulate, resulting in a cooling of the fan motor 114.

As described herein, the use of cooler air, such as air from the second air volume 204, creates a blanket of air around the fan motor 114 that protects the fan motor from the higher temperature rejection air from the heat exchangers 104(e.g., the first air volume). This cooler air bypasses the hot air, and the low pressure inside the heat exchangers 104 created by the fan blades 110 causes air to move through the coolant entry duct 202. The second air volume inlet 206 prevents mixing with the mainstream flow and forms a layer of cooler air over the fan motor 114.

The herein-described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

Those skilled in the art will recognize that it is common within the art to describe devices and/or processes in the fashion set forth herein, and thereafter use engineering practices to integrate such described devices and/or processes into power and/or data processing systems. That is, at least a portion of the devices and/or processes described herein can be integrated into a data processing system via a reasonable amount of experimentation. Those having skill in the art will recognize that a typical power and/or data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical power and/or data processing system may be implemented utilizing any suitable commercially available components, such as those typically found in power and/or data computing/communication and/or network computing/communication systems.

It is further contemplated that each of the examples of the method described above may include any other step(s) of any other method(s) described herein. In addition, each of the examples of the method described above may be performed by any of the systems described herein.

It will be understood by those within the art that, in general, terms used herein, and especially in the appended claims (e.g., bodies of the appended claims) are generally intended as "open" terms (e.g., the term "including" should be interpreted as "including but not limited to," the term "having" should be interpreted as "having at least," the term "includes" should be interpreted as "includes but is not limited to," etc.).

While particular aspects of the present subject matter described herein have been shown and described, it will be apparent to those skilled in the art that, based upon the teachings herein, changes and modifications may be made without departing from the subject matter described herein. It is to be understood that the invention is defined by the appended claims.

Disclosed herein are also the following clauses:
1. A heat rejection fan assembly comprising: a set of fan blades: a fan motor coupled to the set of fan blades via a motor shaft and configured to cause the set of fan blades to: cause a first air volume to move through a heat exchanger, and move the first air volume through a shroud opening; and a fan motor cooling sub-system configured to cool the fan motor.
2. The heat rejection fan assembly of clause 1, wherein the fan motor cooling sub-system comprises a coolant entry duct configured to selectively cause a second air volume to contact the fan motor.
3. The heat rejection fan assembly of clause 2, wherein the second air volume is not moved through the heat exchanger.
4. The heat rejection fan assembly of clause 2, wherein the fan motor cooling sub-system further comprises a coolant exit duct configured to direct the second air volume away from the fan motor.
5. The heat rejection fan assembly of clause 2, further comprising a cooling duct fan disposed within the coolant entry duct.
6. The heat rejection fan assembly of clause 2, wherein the set of fan blades comprises a hub, wherein the hub comprises a set of cooling fins configured to direct the second air volume through the shroud opening.
7. The heat rejection fan assembly of clause 2, wherein the coolant entry duct includes one or more inlets, wherein the one or more inlets include one or more inlets that face away from the heat exchanger.
8. The heat rejection fan assembly of clause 7, wherein one or the one or more inlets are positioned orthogonal to the motor shaft.
9. The heat rejection fan assembly of clause 1, wherein the fan motor cooling sub-system comprises: a heat sink; coolant lines thermally coupled to the heat sink; and a pump configured to circulate the coolant through the coolant lines.
10. A heat rejection unit comprising: a shroud comprising a shroud opening; a heat rejection coil disposed within the shroud; and a heat rejection fan assembly, the heat rejection fan assembly comprising: a set of fan blades: a fan motor coupled to the set of fan blades via a motor shaft and configured to cause the set of fan blades to: cause a first air volume to move through a heat rejection coil, and move the first air volume through a shroud opening; and a fan motor cooling sub-system configured to cool the fan motor.
11. The heat rejection unit of clause 10, wherein the fan motor cooling sub-system comprises a coolant entry duct configured to selectively cause a second air volume to contact the fan motor.
12. The heat rejection unit of clause 11, wherein the fan motor cooling sub-system further comprises a coolant exit duct configured to direct the second air volume away from the fan motor.
13. The heat rejection unit of clause 11, further comprising a cooling duct fan disposed within the coolant entry duct.
14. The heat rejection unit of clause 11, wherein the set of fan blades comprises a hub, wherein the hub comprises a set of cooling fins configured to direct the second air volume through the shroud opening.
15. The heat rejection unit of clause 11, wherein the second air volume is not moved through the heat rejection coil.
16. The heat rejection unit of clause 11, wherein the coolant entry duct includes one or more inlets, wherein the one or more inlets include one or more inlets that face away from the heat rejection coil.
17. The heat rejection unit of clause 16, wherein one or the one or more inlets are positioned orthogonal to the motor shaft.
18. The heat rejection unit of clause 10, wherein the fan motor cooling sub-system comprises: a heat sink; coolant lines thermally coupled to the heat sink; and a pump configured to circulate the coolant through the coolant lines.
19. The heat rejection unit of clause 10, wherein the fan motor cooling sub-system comprises: a heat sink cooled by a circulating coolant.
20. The heat rejection fan assembly of clause 1, wherein the fan motor cooling sub-system comprises: a heat sink; cooled by a circulating coolant.

Described herein is also:
Clause B1. A fan motor cooling sub-system for a heat rejection fan assembly, wherein the heat rejection fan assembly is configured to cause a first air volume to move through a heat exchanger, the fan motor cooling sub-system comprising: a coolant entry duct fluidly couplable to a fan motor comprising: a second air volume outlet disposed near a fan motor; and a second air volume inlet disposed at a second air volume, wherein the second air volume moves from the second air volume inlet to the second air volume outlet and cools the fan motor.
Clause B2: The heat rejection fan assembly of clause B1, further comprising a cooling duct fan disposed within the coolant entry duct and configured to force the second air volume against the fan motor.

## Claims

1. A heat rejection fan assembly comprising:
a set of fan blades:
a fan motor coupled to the set of fan blades via a motor shaft and configured to cause the set of fan blades to:
cause a first air volume to move through a heat exchanger, and
move the first air volume through a shroud opening; and
a fan motor cooling sub-system configured to cool the fan motor.

2. The heat rejection fan assembly of claim 1, wherein the fan motor cooling sub-system comprises a coolant entry duct configured to selectively cause a second air volume to contact the fan motor.

3. The heat rejection fan assembly of claim 2, wherein the second air volume is not moved through the heat exchanger.

4. The heat rejection fan assembly of any one of the claims 2 to 3, wherein the fan motor cooling sub-system further comprises a coolant exit duct configured to direct the second air volume away from the fan motor.

5. The heat rejection fan assembly of any one of the claims 2 to 4, further comprising a cooling duct fan disposed within the coolant entry duct;
and optionally wherein the cooling duct fan is configured to force the second air volume against the fan motor.

6. The heat rejection fan assembly of any one of the claims 2 to 5, wherein the set of fan blades comprises a hub, wherein the hub comprises a set of cooling fins configured to direct the second air volume through the shroud opening.

7. The heat rejection fan assembly of any one of the claims 2 to 6, wherein the coolant entry duct comprises one or more inlets, wherein the one or more inlets comprise one or more inlets that face away from the heat exchanger.

8. The heat rejection fan assembly of claim 7, wherein one or the one or more inlets are positioned orthogonal to the motor shaft.

9. The heat rejection fan assembly of any one of the preceding claims, wherein the fan motor cooling sub-system comprises:
a heat sink;
coolant lines thermally coupled to the heat sink; and
a pump configured to circulate the coolant through the coolant lines.

10. A heat rejection unit comprising:
a shroud comprising a shroud opening;
a heat rejection coil disposed within the shroud; and
a heat rejection fan assembly according to any one of the preceding claims.

11. The heat rejection unit of claim 10, wherein the heat exchanger is a heat rejection coil.

12. The heat rejection unit of claim 10,
wherein a coolant entry duct is fluidly couplable to the fan motor comprising:
a second air volume outlet disposed near the fan motor; and
a second air volume inlet disposed at a second air volume, wherein the second air volume moves from the second air volume inlet to the second air volume outlet and cools the fan motor.

13. A method for controlling a temperature of a fan motor of a heat rejection fan assembly according to any one of the claims 1 to 9, the method comprising:
receiving a temperature measurement from a sensor;
comparing the temperature measurement to a threshold;
when the temperature measurement is above the threshold, causing a coolant to circulate to cool the fan motor.

14. The method of claim 13 further comprising:
activating a coolant pump.

15. The method of any one of the claims 13 to 14, further comprising
measuring, by the sensor, the temperature of the fan motor.
